# EUROPEAN PATENT APPLICATION

(11) **EP 4 576 192 A1**
(43) Date of publication of application: **25.06.2025**
(21) Application number: 23217873.1
(22) Date of filing: 19.12.2023
(51) Int. Cl.: H01L 21/8238, H01L 27/092, H01L 29/06, H01L 29/66, H01L 29/775, H01L 29/786

(54) **FET DEVICE AND METHOD OF FABRICATING A FET DEVICE**

(71) Applicant: Imec VZW, 3001 Leuven (BE); Huawei Technologies Co., Ltd., Longgang Shenzhen, Guangdong 518129 (CN)
(72) Inventor: Gaddemane, Gautam, 3010 Leuven (BE); Bhuwalka, Krishna Kumar, 3001 Heverlee (BE); Liu, Changze, 3001 Heverlee (BE); Hellings, Geert, 1500 Halle (BE)
(74) Representative: Roth, Sebastian

(57) **Abstract**

The disclosure relates a FET device (10), in particular a forksheet device. The FET device (10) comprises: a first nanolayer structure (11) which comprises one or more first channel layers (na-c); a second nanolayer structure (12) which comprises one or more second channel layers (12a-c); and a dielectric isolation barrier (13) which is arranged to separate the first nanolayer structure (11) from the second nanolayer structure (12), wherein the dielectric isolation barrier (13) is in direct contact with the first and the second nanolayer structure (12) and extends along a first axis; wherein a width of the first nanolayer structure (11) along a second axis, which is perpendicular to the first axis, is smaller than a width of the second nanolayer structure (12) along the second axis.

## Description

### TECHNICAL FIELD

The present disclosure refers to a FET device, in particular a forksheet device, and to a method of fabricating a FET device.

### BACKGROUND

A fin field-effect transistor (FinFET) is a type of metal-oxide semiconductor field effect transistor (MOSFET) with a fin shaped channel between the source and drain terminals. The gate is arranged on two or three sides of the fin shaped channel and can surround the channel. Compared to a conventional planar MOSFET, such as bulk or SOI, a FinFET allows for faster switching times and higher current densities.

The semiconductor manufacturing sector is presently shifting from FinFET to a gate-all-around (GAA) nanosheet (NS) design. In the GAA-NS architecture, a number of horizontally stacked nanosheets, which form the channels of the transistor, are completely surrounded by a gate. The shift to this GAA-NS design is imperative to extend scaling beyond the 5nm technology node, aiming for enhanced gate control and decreased short-channel effects. However, the ability of the GAA-NS design to facilitate cell area scaling is constrained. The primary challenge with the GAA-NS technology revolves around maintaining a minimum separation between NMOS and PMOS devices, which is essential to avert capacitance and process-related complications. Consequently, this imposes an upper limit on cell area scaling.

This obstacle can be overcome by the so-called forksheet architecture. In a forksheet FET, the NMOS and PMOS devices are fabricated on opposing sides of a dielectric wall, rather than as distinct layers as in the traditional nanosheet approach. This reduces the spacing between the NMOS and PMOS devices, enables more flexibility in scaling of the cell height and allows for employing broader sheets for an increased performance. Conventional forksheet devices have a symmetric architecture with a centrally placed dielectric wall.

In such a forksheet FET, the NMOS to PMOS drive currents should be at a certain ratio to achieve an optimized performance. However, in silicon-based devices, the PMOS component typically exhibits a lower drive current compared to NMOS, due to the inherently lower mobility of holes compared to electrons. Thus, the hole mobility in the PMOS device should be enhanced which can be achieved by applying stress to the PMOS device. However, while such stress augmentation can boost the hole mobility, it leads to additional challenges and complications, such as stress-induced defects.

Furthermore, by enhancing the sheet width of the NMOS and PMOS devices, the drive current can be increased, consequently enhancing operational speed. However, this upsurge in sheet widths also leads to amplified gate and parasitic capacitance (with gate extension maintained constant, gate width is contingent on sheet width), ultimately resulting in a reduction in speed.

### SUMMARY

Thus, it is an objective to provide an improved FET device and an improved method of fabricating a FET device. In particular, the above-mentioned disadvantages should be avoided.

The objective is achieved by the embodiments provided in the enclosed independent claims. Advantageous implementations of the embodiments of the invention are further defined in the dependent claims.

A first aspect of this disclosure provides a field-effect transistor (FET) device, in particular a forksheet device. The FET device comprises: a first nanolayer structure which comprises one or more first channel layers; a second nanolayer structure which comprises one or more second channel layers; and a dielectric isolation barrier which is arranged to separate the first nanolayer structure from the second nanolayer structure, wherein the dielectric isolation barrier is in direct contact with the first and the second nanolayer structure and extends along a first axis; wherein a width of the first nanolayer structure along a second axis, which is perpendicular to the first axis, is smaller than a width of the second nanolayer structure along the second axis.

This achieves the advantage that a FET device, in particular a forksheet device, with an asymmetric design is provided, wherein the asymmetry enhances the device performance compared to a conventional symmetric design with a centrally placed isolation and equal NMOS/PMOS width.

For example, the first nanolayer structure is arranged on the NMOS side and the second nanolayer structure on the PMOS side of the FET device. Due to the reduced width of the first (NMOS) nanolayer structure, the parasitic capacitance on the NMOS side can be effectively lowered, while simultaneously the larger width of second (PMOS) nanolayer structure can increase a drive current. These adjustments can synergistically contribute to an overall enhancement of the FET device performance. In addition, the introduction of additional stress on the PMOS side can be avoided, which reduces stress-induced defects.

In particular, the second axis is perpendicular to the first axis and to a stacking direction of the respective channel layers of each nanolayer structure.

The FET device can be a forksheet device (also referred to as: forksheet FET device).

The channel layers can be nanolayers. The channel layers of each nanolayer structure can be arranged one above the other and at a distance from each other. Thus, there is a gap between each two channel layers of a nanolayer structure, which can be filled by a respective gate stack material.

In an embodiment, the width of the first nanolayer structure is at least 10% smaller than the width of the second nanolayer structure. This achieves an advantage that an asymmetry is introduced which effectively increases the device performance.

In an embodiment, the first nanolayer structure is a p-type structure and the second nanolayer structure is an n-type structure, or vice versa.

Being n-type or p-type can be achieved in different manner, such as: doping of the channel layers and/or doping of the source/drain regions and/or providing n-type or p-type gate stacks.

For instance, the one or more first channel layers of the first nanolayer structure are n-channel nanolayers. The one or more first channel layers of the first nanolayer structure can be p-channel nanolayers. The n-channel and/or p-channel nanolayers may be Si or Ge based.

In an embodiment, the FET device further comprises a first gate structure which surrounds each of the one or more first channel layers of the first nanolayer structure on three sides. For example, the first gate structure is formed from an n-type work function metal.

In an embodiment, the FET device further comprises a second gate structure which surrounds each of the one or more second channel layers of the second nanolayer structure on three sides. For example, the second gate structure is formed from a p-type work function metal.

In an embodiment, the dielectric isolation barrier is formed from any one of the following materials: SiN, SiC, SiOCN, SiCN,SiO₂, SiCO, or SiON.

A second aspect of this disclosure provides a method of fabricating a FET device, in particular a forksheet device. The method comprises: forming a first nanolayer structure which comprises one or more first channel layers; forming a second nanolayer structure which comprises one or more second channel layers; and forming a dielectric isolation barrier which separates the first nanolayer structure from the second nanolayer structure and is in direct contact with the first and the second nanolayer structure, wherein the dielectric isolation barrier extends along a first axis; wherein a width of the first nanolayer structure along a second axis, which is perpendicular to the first axis, is smaller than a width of the second nanolayer structure along the second axis.

This achieves the advantage that a FET device, in particular a forksheet device, with an asymmetric design is provided, wherein the asymmetry enhances the device performance compared to a conventional symmetric design with a centrally placed isolation and equal NMOS/PMOS width.

In an embodiment, the width of the first nanolayer structure is at least 10% smaller than the width of the second nanolayer structure. This achieves an advantage that an asymmetry is introduced which efficiently increases the device performance.

In an embodiment, the first nanolayer structure is a p-type structure and the second nanolayer structure is an n-type structure, or vice versa.

In an embodiment, the dielectric isolation barrier is formed by: etching a trench in a substrate which comprises the first and the second nanolayer structures, and filling the trench with a dielectric isolation material.

In an embodiment, the dielectric isolation barrier is formed from materials any one of the following materials: SiN, SiC, SiOCN, SiCN,SiO₂, SiCO, or SiON.

In an embodiment, the method further comprises: forming a first gate structure which surrounds each of the one or more first channel layers of the first nanolayer structure on three sides. For example, the first gate structure is formed from an n-type work function metal.

In an embodiment, the method further comprises: forming a second gate structure which surrounds each of the one or more second channel layers of the second nanolayer structure on three sides. For example, the first gate structure is formed from an p-type work function metal.

### BRIEF DESCRIPTION OF THE DRAWINGS

The above described aspects and implementations are explained in the following description of embodiments with respect to the enclosed drawings:
- FIG. 1: shows a schematic diagram of a FET device according to an embodiment;
- FIG. 2: shows results of performance simulations of FET devices according to an embodiment; and
- FIGS. 3A-C: shows steps of a method of fabricating a FET device according to an embodiment.

### DETAILED DESCRIPTION OF EMBODIMENTS

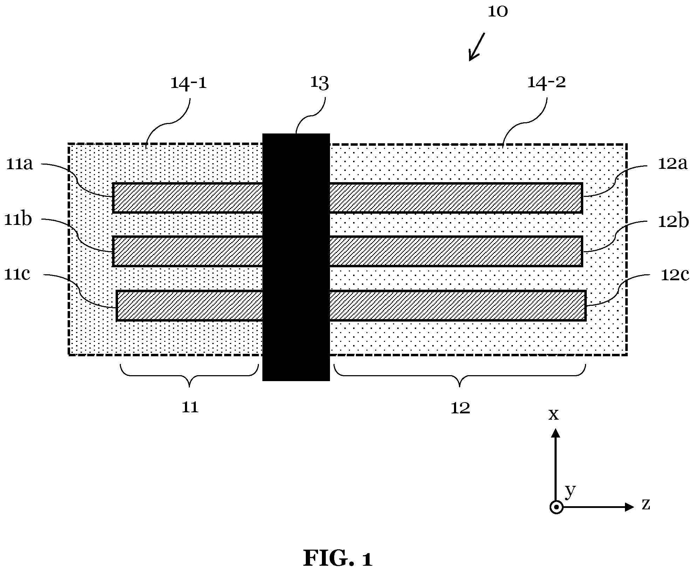

FIG. 1 shows a schematic diagram of a FET device 10 according to an embodiment. The FET device 10 can be a forksheet device or (i.e., a FET device with a forksheet architecture).

The FET device 10 comprises a first nanolayer structure 11 which comprises one or more first channel layers 11a-c; a second nanolayer structure 12 which comprises one or more second channel layers 12a-c; and a dielectric isolation barrier 13 which is arranged to separate (i.e. isolate) the first nanolayer structure 11 from the second nanolayer structure 12. The dielectric isolation barrier 13 (i.e. dielectric wall) is in direct contact with the first and the second nanolayer structure 11, 12 and extends along a first axis; wherein a width of the first nanolayer structure 11 along a second axis, which is perpendicular to the first axis, is smaller than a width of the second nanolayer structure 12 along the second axis.

For instance, in FIG. 1, the first axis is the y-axis (e.g., the channel direction from a source to a drain) and the second axis is the z-axis of the Cartesian coordinate system. The dielectric isolation barrier 13 can also extend along a stacking direction of the channel layers 11a-c, 12a-c, which is the x-axis in FIG. 1. The second axis (z-axis) is also perpendicular to this stacking direction (x-axis).

The widths of the first and second nanolayer structures 11, 12 may refer to the width of their respective channel layers 11a-c, 12a-c. This channel layer width can also be referred to as "active width". The channel layers can be nanolayers (i.e., layers with a nanoscale height) respectively nanosheets.

The difference in width between the first and the second nanolayer structures 11, 12 can be achieved by a non-central placement of the dielectric isolation barrier 13. As shown in FIG. 1, the barrier 13 can be arranged shifted to one side (along the z-axis) of the FET device 10.

The dielectric isolation barrier 13 being in direct contact with the nanolayer structures 11, 12 may refer to the barrier 13 being in physical contact with the nanolayer structures 11, 12, in particular with the individual channel layers 11a-c, 12a-c of the nanolayer structures 11, 12. The dielectric isolation barrier 13 can support the channel layers 11a-c, 12a-c and, at the same time, separate the layers of the first nanolayer structure 11 form the layers of the second nanolayer structure 12.

The one or more first channel layers 11a-c of the first nanolayer structure 11 can be n-channel nanolayers, and the one or more second channel layers 12a-c of the second nanolayer structure 12 can be p-channel nanolayers. The first and second nanolayer structure 11, 12 are preferably of opposite type (e.g., n-type and p-type).

In particular, the first nanolayer 11 structure can be a p-type structure and the second nanolayer structure 12 can be an n-type structure, or vice versa. Being n-type or p-type can then be achieved in different manners like: doping of the channel layers and/or doping of the source/drain regions and/or providing n-type or p-type gate stacks.

For example, the FET device 10 comprises a NMOS structure on one side of the dielectric isolation barrier 13, wherein the NMOS structure comprises the first nanolayer structure 11. The FET device 10 can further comprise a PMOS structure on the opposite side of the dielectric isolation barrier 13, wherein the PMOS structure comprises the second nanolayer structure 12. In this way, an asymmetry between the active widths of the NMOS and PMOS structures can be achieved.

In contrast, a conventional forksheet design uses identical active widths for both NMOS and PMOS structures (i.e., a 1:1 ratio of the widths). Achieving an optimal performance typically necessitates a specific drive current ratio between PMOS and NMOS. Due to the inherent disparity in hole mobility compared to electron mobility, the PMOS drive current typically lags behind that of NMOS. In a conventional symmetric forksheet device, matching NMOS and PMOS performance can be achieved by application of stress to the PMOS, which enhances a hole mobility in PMOS but at the same time introduces stress-induced defects.

With the asymmetric FET design, as shown in FIG. 1, the active width of the NMOS structure (i.e., the width of first channel layers 11a-c) can be reduced, which effectively reduces an unwanted parasitic capacitance at the NMOS side. At the same time, the active width of the PMOS structure (i.e., the width of second channel layers 12a-c) can be enhanced, which amplifies its drive current. Thus, the disadvantages of the conventional (symmetric) design can be mitigated. Furthermore, the asymmetric widths of NMOS and PMOS can mitigate stress-related challenges in PMOS, as it is no longer necessary to introduce additional stress to enhance the hole mobility on the PMOS side, and further promotes the feasibility of cell scaling.

For instance, the width of the first nanolayer structure 11 is at least 10% smaller than the width of the second nanolayer structure 12. This asymmetry can ensure a noticeable increase in the FET device 10 performance. However, an optimal or minimal asymmetry might depend on many factors, such as the exact materials of the channel layers 11a-c, 12a-c and gate structures 14-1, 14-2. Thus, depending on these factors and/or the performance goals to be reached, the width of the first nanolayer structure 11 can be at least 5%, 10%, 15%, 20%, 25 % or 30% smaller than the width of the second nanolayer structure 12.

The dielectric isolation barrier 13 can be formed from a dielectric material. For instance, the dielectric material is any one of the following materials: SiN, SiC, SiOCN, SiCN,SiO2, SiCO, or SiON.

The first and the second nanolayer structures 11, 12 and the dielectric isolation barrier 13 can be arranged on or in a substrate.

The FET device 10 may further comprise a first gate structure 14-1 which surrounds each of the one or more first channel layers 11a-c of the first nanolayer structure on three sides, and a second gate structure 14-2 which surrounds each of the one or more second channel layers 12a-c of the second nanolayer structure 12 on three sides.

For example, the first gate structure 14-1 is formed from an n-type work function metal, and the second gate structure 14-2 is formed from a p-type work function metal.

Moreover, the FET device 10 may comprise source and drain structures, which can be arranged to electrically contact the first and/or second nanolayer structures 11, 12 (in particular, the respective channel layers 11a-c, 12a-c). The source and drain structures can be arranged along the channel direction (y-axis in FIG. 1) in front of and behind the gate structures 14-1, 14-2, respectively.

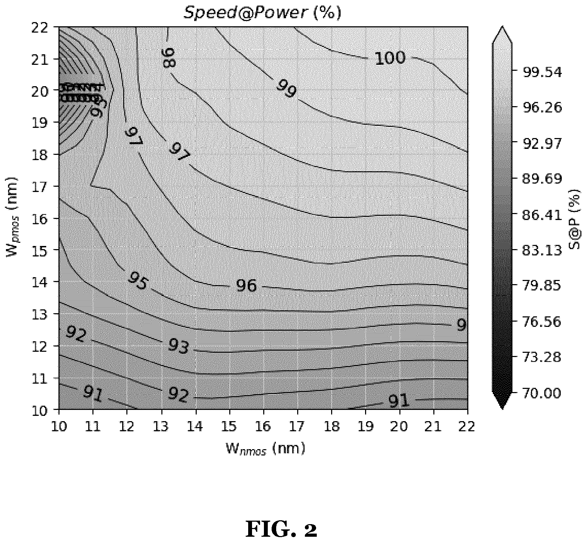

FIG. 2 shows results of performance simulations of FET devices according to an embodiment.

Thereby, a variation of the (switching) speed (in %) at a fixed power was calculated for a simulated FET device 10, as shown in FIG. 1, with varying NMOS and PMOS widths (i.e., different active widths of the first and the second nanolayer structures 11, 12, wherein the first nanolayer structure 11 is on the NMOS side and the second nanolayer structure 12 is on the PMOS side of the FET device 10).

The simulation results show that the width (W_{NMOS}) of the (first) NMOS nanolayer structure 11 can generally be further reduced than the width (W_{PMOS}) of the (second) PMOS nanolayer structure 12 before this negatively affects the FET speed. For instance, at a W_{PMOS} between 21 and 22 nm, W_{NMOS} can be reduced to ca. 18 nm to maintain the speed at 100%. Thus, in this example W_{NMOS} can be made ca. 15% smaller than W_{PMOS} without any loss of performance. If a speed of 97% is to be reached, a W_{PMOS} of 18 nm can be combined with a W_{NMOS} of 14 nm (i.e., W_{NMOS} can be ca. 22% smaller than W_{PMOS}).

These simulation outcomes demonstrate that the asymmetric forksheet design can significantly optimize speed / delay performance of the FET device 10. Even with a narrower active width for NMOS in comparison to PMOS (and thus a smaller overall form factor), an optimal performance can be maintained. In particular, the asymmetric FET device 10 can have a better PPA (power, performance, and area) point than a comparable device with a conventional (symmetric) design. This shows that a manipulation of sheet widths and/or dielectric wall placement can improve a FET functionality. In addition to improving performance, the introduction of stress to improve hole mobility in PMOS can be avoided. In addition, cell scaling could be improved, as the size of the NMOS component can be reduced.

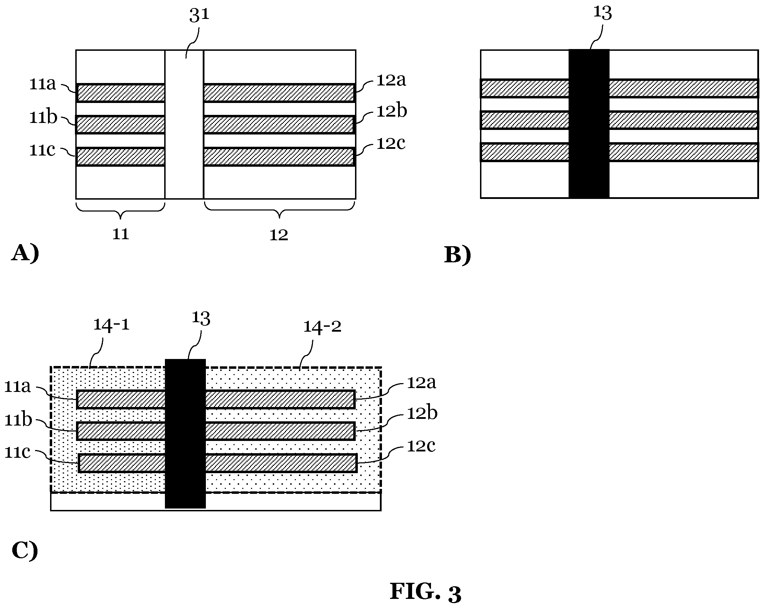

FIGS. 3A-C shows steps of a method of fabricating the FET device 10 according to an embodiment.

As shown in FIG. 3A, the method comprises forming the first nanolayer structure 11 which comprises the one or more first channel layers 11a-c; and forming the second nanolayer structure 12 which comprises one or more second channel layers 12a-c.

The first and the second nanolayer structures 11, 12 may be formed side by side on or in a substrate (i.e., the substrate can comprise the first and the second nanolayer structures 11, 12). Each nanolayer structure 11, 12 may initially comprise alternating nanolayers. The alternating nanolayers can comprise the first respectively second channel layers 11a-c, 12a-c, alternately arranged with further nanolayers (which can be removed in a later step, so-called sacrificial nanolayers).

The first respectively second channel layers 11a-c, 12a-c can be silicon (Si) layers and the further nanolayers can be SiGe layers.

The first and the second nanolayer structures 11, 12 can be separated by a trench 31, which can be formed by a patterning and/or an etching process.

As shown in FIG. 3B, the method can further comprise: forming the dielectric isolation barrier 13 which separates the first nanolayer structure 11 from the second nanolayer structure 12 and is in direct contact with the first and the second nanolayer structures 11, 12, wherein the dielectric isolation 13 barrier extends along the first axis.

For example, the material of the dielectric isolation barrier 13 can be filled in the trench 31 which separates the first from the second nanolayer structure 11, 12.

The isolation barrier 13 is arranged, such that the width of the first nanolayer structure 11 along the second axis, which is perpendicular to the first axis, is smaller than a width of the second nanolayer structure 12 along the second axis. For example, the width of the first nanolayer structure 11 is at least 10% smaller than the width of the second nanolayer structure 12.

The dielectric isolation barrier 13 can be formed from a dielectric isolation material. This material can be any one of the following: SiN (or Si₃N₄), SiC, SiOCN, SiCN,SiO2, SiCO, or SiON.

Subsequent to the filling of the trench 31, material can be recessed on the respective outer side of the first and the second nanolayer structures 11, 12 (i.e., on the side facing away from the isolation barrier 13) to generate a fin structure. The fin structure can comprise the nanolayer structures 11, 12 and the isolation barrier 13.

As shown in FIG. 3C, the method can further comprise: forming the first gate structure 14-1 which surrounds each of the one or more first channel layers 11a-c of the first nanolayer structure 11 on three sides, and forming the second gate structure 14-2 which surrounds each of the one or more second channel layers 12a-c of the second nanolayer structure 12 on three sides.

Prior to forming the gates, the further nanolayers (e.g., SieGe layers) between the first channel layers 11a-c and second channel layers 12a-c can be selectively removed. Then, the gate material(s) of the first and second gate structures 14-1, 14-2 can be deposited. Due to the removal of the further nanolayers in-between the channel layers, the respective gate material can surround each of the channel layers 11a-c, 12a-c on three sides.

The gate materials can be gate metals. For instance, the first gate structure 14-1 is formed from an n-type work function metal and the second gate structure 14-2 is formed from a p-type work function metal.

With the method as shown in FIGS. 3A-C, the FET device 10 can the formed as an asymmetric forksheet device with an NMOS side that has a lower active width than the PMOS side.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A FET device (10), in particular a forksheet device, comprising:
a first nanolayer structure (11) which comprises one or more first channel layers (11a-c);
a second nanolayer structure (12) which comprises one or more second channel layers (12a-c); and
a dielectric isolation barrier (13) which is arranged to separate the first nanolayer structure (11) from the second nanolayer structure (12), wherein the dielectric isolation barrier (13) is in direct contact with the first and the second nanolayer structure (12) and extends along a first axis;
wherein a width of the first nanolayer structure (11) along a second axis, which is perpendicular to the first axis, is smaller than a width of the second nanolayer structure (12) along the second axis.

2. The FET device (10) of claim 1,
wherein the width of the first nanolayer structure (11) is at least 10% smaller than the width of the second nanolayer structure (12).

3. The FET device (10) of claim 1 or 2,
wherein the first nanolayer structure (11) is a p-type structure and the second nanolayer structure (12) is an n-type structure, or vice versa.

4. The FET device (10) of any one of the preceding claims, further comprising:
a first gate structure (14-1) which surrounds each of the one or more first channel layers (iia-c) of the first nanolayer structure (11) on three sides.

5. The FET device (10) of any one of the preceding claims, further comprising:
a second gate structure (14-2) which surrounds each of the one or more second channel layers (12a-c) of the second nanolayer structure (12) on three sides.

6. The FET device (10) of any one of the preceding claims,
wherein the dielectric isolation barrier (13) is formed from any one of the following materials: SiN, SiC, SiOCN, SiCN,SiO₂, SiCO, or SiON.

7. A method of fabricating a FET device (10), in particular a forksheet device, comprising:
forming a first nanolayer structure (11) which comprises one or more first channel layers (11a-c);
forming a second nanolayer structure (12) which comprises one or more second channel layers (12a-c); and
forming a dielectric isolation barrier (13) which separates the first nanolayer structure (11) from the second nanolayer structure (12) and is in direct contact with the first and the second nanolayer structure (12), wherein the dielectric isolation barrier (13) extends along a first axis;
wherein a width of the first nanolayer structure (11) along a second axis, which is perpendicular to the first axis, is smaller than a width of the second nanolayer structure (12) along the second axis.

8. The method of claim 7,
wherein the width of the first nanolayer structure (11) is at least 10% smaller than the width of the second nanolayer structure (12).

9. The method of claim 7 or 8,
wherein the dielectric isolation barrier (13) is formed by:
etching a trench in a substrate which comprises the first and the second nanolayer structure (12), and
filling the trench with a dielectric isolation material.

10. The method of any one of claims 7 to 9,
wherein the first nanolayer structure (11) is a p-type structure and the second nanolayer structure (12) is an n-type structure, or vice versa.

11. The method of any one of claims 7 to 10,
wherein the dielectric isolation barrier (13) is formed from any one of the following materials: SiN, SiC, SiOCN, SiCN,SiO₂, SiCO, or SiON.

12. The method of any one of claims 7 to 11, further comprising:
forming a first gate structure (14-1) which surrounds each of the one or more first channel layers (iia-c) of the first nanolayer structure (11) on three sides.

13. The method of any one of claims 7 to 12, further comprising:
forming a second gate structure (14-2) which surrounds each of the one or more second channel layers (12a-c) of the second nanolayer structure (12) on three sides.
